# EUROPEAN PATENT SPECIFICATION

(11) **EP 2 556 453 B1**
(45) Date of publication and mention of the grant of the patent: **19.03.2014**
(21) Application number: 11711581.6
(22) Date of filing: 01.04.2011
(51) Int. Cl.: G06F 17/50

(54) **METHOD IMPLEMENTED IN A COMPUTER FOR THE NUMERICAL SIMULATION OF SEMICONDUCTOR DEVICES CONTAINING TUNNEL JUNCTIONS**
IN EINEM COMPUTER IMPLEMENTIERTES VERFAHREN ZUR NUMERISCHEN SIMULATION VON HALBLEITERVORRICHTUNGEN MIT TUNNELÜBERGÄNGEN
PROCÉDÉ MIS EN OEUVRE PAR ORDINATEUR DE SIMULATION NUMÉRIQUE DE DISPOSITIFS À SEMI-CONDUCTEUR CONTENANT DES JONCTIONS À EFFET TUNNEL

(30) Priority: 05.04.2010 EP 10382076
(43) Date of publication of application: 13.02.2013
(73) Proprietor: Universidad Politécnica De Madrid, 28040 Madrid (ES)
(72) Inventor: GARCÍA VARA, Iván, E-28040 Madrid (ES); ESPINET GONZÁLEZ, Pilar, E-28040 Madrid (ES); ALGORA DEL VALLE, Carlos, E-28040 Madrid (ES); BAUDRIT, Mathieu, E-28040 Madrid (ES); REY-STOLLE PRADO, Ignacio, E-28040 Madrid (ES)
(74) Representative: ABG Patentes, S.L.
(86) International application number: PCT/EP2011/055086
(87) International publication number: WO 2011/124530

(56) References cited:
- GARCIA I ET AL: "Study of non-uniform light profiles in high concentration III-V solar cells using quasi-3D distributed models", PHOTOVOLTAICS SPECIALISTS CONFERENCE, 2008, 33RD IEEE,EEE, PISCATAWAY, NJ, USA, 16 May 2008 (2008-05-16), pages 1-6, XP002601370, ISBN: 978-1-4244-1640-0
- JEFFREY F WHEELDON ET AL: "AlGaAs tunnel junction for high efficiency multi-junction solar cells: Simulation and measurement of temperature-dependent operation", PHOTOVOLTAIC SPECIALISTS CONFERENCE (PVSC), 2009 34TH IEEE, IEEE, PISCATAWAY, NJ, USA, 7 June 2009 (2009-06-07), pages 106-111, XP031626917, ISBN: 978-1-4244-2949-3
- GALIANA B ET AL: "A 3-D model for concentrator solar cells based on distributed circuit units", IEEE TRANSACTIONS ON ELECTRON DEVICES IEEE USA, vol. 52, no. 12, December 2005 (2005-12), pages 2552-2558, XP002601371, ISSN: 0018-9383
- VIJAY K NARASIMHAN ET AL: "Effect of parameter variations on the current-voltage behavior of AlGaAs tunnel junction models", MICROSYSTEMS AND NANOELECTRONICS RESEARCH CONFERENCE, 2008. MNRC 2008. 1ST, IEEE, PISCATAWAY, NJ, USA, 15 October 2008 (2008-10-15), pages 165-168, XP031364428, ISBN: 978-1-4244-2920-2

## Description

### OBJECT OF THE INVENTION

The present invention is directed to a method implemented in a computer for the numerical simulation of a semiconductor device which contains one or more tunnel junctions and allows the simulation for all the working range of the tunnel junction.

The method is based on a distributed model where the tunnel junction can be integrated in the simulation by means of distributed electronic circuits of a semiconductor device and, specially, of multijunction solar cells.

The said method is used to circumvent the convergence problems existing so far and allows in particular the full description of the experimental behavior of the multijunction solar cells and, by extension, of any kind of semiconductor device containing tunnel junctions.

### BACKGROUND OF THE INVENTION

Over the last decade, the efficiency of the semiconductor devices with tunnel junctions and, in particular, of multijunction solar cells, has increased considerably. One of the key aspects in this efficiency increase has been the improvements in the fabrication of the tunnel junctions which connect monolithically each subcell *(*M.Yamaguchi, T.Takamoto, K.Araki, "Super high-efficiency multi-function and concentrator solar cells". Solar Energy Materials and Solar Cells 90 (18-19), p. 3068-3077 (2006*)].*

The simulation models are fundamental to a detailed understanding of the multijunction solar cells operating principles as well as for their optimum design and fabrication. The more powerful simulation methods to date are two:
1) Numerical simulation of the differential equations describing the semiconductor device.
2) Simulation by means of distributed electronic circuits.

Numerical simulations consist in dividing the solar cell into portions with appropriate contour conditions which allow to solve the set of differential equations which describe the semiconductor device, typically the continuity equations for the minority carriers and Poisson's equation.*[*S.J. Fonash, Solar Cell Device Physics, Academic Press, New York (1981*)].* This way, the electrical response of the solar cell can be known for given illumination and electrical polarization conditions. *[*H. Eschrich, A. Ringhandt, B. Reinicke, G. Nishwitz, H.G. Wagenmann, "Analysis of the Window Layer of AlxGa1-xAs/GaAs Solar Cells aided by Numerical Simulation", Proc. of the 11th European PVSC, p. 897-900, 1992*].*

In the distributed simulation using electronic components, the solar cell is divided into small portions, the so-called **elemental units.** An equivalent circuit is assigned to each elemental unit, depending on its geometrical characteristics and its position inside the solar cell area (typically perimeter, covered or exposed area). Consequently, the whole solar cell is modeled using the resulting circuit obtained by the interconnection of circuits from all elemental units, joining adjacent units to each other. *[*B. Galiana, C. Algora, I. Rey-Stolle, I. Garcia. "A 3D model for concentrator solar cells based on distributed circuit units". IEEE Trans. Electron Devices 52 (12), p. 2552-2558 (2005*)].*

The main advantages of the simulations by means of distributed electronic circuits, opposite to simulation by means of solving differential equations, are mainly two: a) a computational cost considerably lower which allows, among others, the simulation of semiconductor devices with a relatively large area (tens of square millimeters, even centimeters), opposite to the reduced size (in the order of the tenth of a millimeter) that can be simulated with the numerical simulations of the differential equations; b) it is not necessary to know all the optical and electrical characteristics of the materials which compose the device, but only their behavior relevant for the equivalent electronic circuit.

These advantages have made possible the prediction of the electric response of the solar cell under different illumination and polarization conditions *[*I. Garcia. C. Algora, I. Rey-Stolle and B. Galiana, "Study of non-uniform light profiles on high concentration III-V solar cells using quasi-3D distributed models". Proc. of the 33rd IEEE Photovoltaic Specialists Conference, San Diego, U.S.A (2008*)],* which has not been yet accomplished satisfactorily by using the differential equations of the semiconductor device.

In spite of these advantages of the distributed simulation by means of electronic circuits, to date no model has been developed for a tunnel junction in a semiconductor device and in particular of a solar cell which considers all the possible working regimes described by its I-V curve (by I-V curve is meant the current-voltage characteristic of, in this case, the tunnel junction).

The characteristic I-V curve of the tunnel junction has different working regions, namely:
a) Ohmic region, which corresponds to a first region with behavior close to the lineal behavior and with a positive slope, up to a current value called the peak current.
b) Negative resistance region, which starts at the peak current and drops with a negative slope until a local minimum is reached, called the valley current.
c) Excess current region, which starts at the valley current and exhibits a positive slope and,
d) Diode region, which exhibits a steeper slope than the excess current region, being its behavior exponential.

Therefore, in the simulation of the tunnel junction, a convergence problem occurs frequently, since for some values of the current (produced, for example, by a given illumination condition in the case of the solar cell) the tunnel junction can have different possible voltage values for the same current level. Mathematically speaking, in this situation the voltage is a multi-valuated function with respect to the current. For this reason, so far the tunnel junction has been modeled as a short circuit *[*K. Nishioka, T. Takamoto, W. Nakajima, T. Agui, M. Kaneiwa, Y. Uraoka, T. Fuyuki, "Analysis of triple-junction solar cell under concentration by spice"', Proceedings of 3rd World Conference on Photovoltaic Energy Conversion, p. 869-872 (2003*)]* or as a resistor *[*I. Rey-Stolle, C. Algora, I. Garcia, M. Baudrit, P. Espinet, B. Galiana, and E. Barrigon, "Simulating III-V concentrator solar cells: a comparison of advantages and limitations of lumped analytical models, distributed analytical models and numerical simulations". Proc. of the 35th IEEE Photovoltaic Specialists Conference, Philadelphia USA, 2009*].* However, these approximations are only valid when the current generated by the solar cell is lower than the peak current, Iₚ, of the tunnel junction.

Actually, what is desirable in the case of solar cells is that they work in the ohmic region, where the curve behavior is always increasing.

The known elemental units comprise models for each part of the semiconductor device. The models used reproduce the behavior of each of these parts and they do not exhibit convergence problems during the solving of the resulting equations.

Cases similar to this invention, in which a method for the accurate simulation of a structure or part of a semiconductor device is proposed, have already been object of a patent. For example, the patent US5535146 describes a method for producing a semiconductor device using a logic simulation approach to simulate a multi-peak resonant tunneling diode (RTD)-based electronic circuit, a large signal multi-peak RTD model for SPICE computer simulation program (a commercial program largely used in circuit simulation)for the logic simulation obviating convergence problems during simulation, that ensures the accurate simulation of the electronic circuit operation, and that facilitates the transmission of circuit data to a computer loaded with the SPICE computer simulation program.

Similarly, it is described in patent US6161212 a model of a semiconductor by means of a junction capacitance in parallel with a junction resistance and a junction inductance. Junction capacitance, resistance, an inductance depend on the voltage of the semiconductor junction and are determined by means of charge probability stored in the junction. The parameters of the junction are determined by means of procedures for extracting such parameters. A circuit simulation program is used to determine the operation of a circuit incorporating the tunnel junction. Consequently, the junction diodes are modeled in a more accurate way for voltages above the built-in voltage and below the breakdown voltage.

The present invention discloses a method for the numerical simulation of a semiconductor device comprising a model for the tunnel junction, particularly applicable in multijunction solar cells, so that it can be simulated without convergence problems for any operation regime of the tunnel junction.

Likewise, as will be shown later, the method according to this invention allows also the simulation of a multijunction solar cell in real operating conditions such as non-uniform light irradiance profiles, the presence of temperature gradients, etc, being this method also applicable to any other semiconductor device containing tunnel junctions.

### DESCRIPTION OF THE INVENTION

The present invention consists in a method implemented in a computer for the numerical simulation of a semiconductor device comprising one or more tunnel junctions, such as a multijunction solar cell.
- *The semiconductor device has a main plane and is described by a model featuring circuit units distributed along this main plane that comprises interconnected elemental circuit units.*
   The device is made up of a semiconductor structure which can be mainly depicted by layers where each layer has a specific function. The main plane is a reference plane so that the layers are essentially arranged in parallel to this main plane. This main plane is usually represented horizontally and the transversal direction which traverses the semiconductor structure is represented vertically.
   The method of the invention makes use of a model based on circuits of electronic components which allows working with said model instead of with the device by means of simulations that allows among others objects to optimize its performance. According to the model based on circuits of electronic components, the device yields divided into elemental units which are distributed throughout the area of the main plane of the semiconductor device.
   In turn, each of these elemental units simulates the behavior of the semiconductor device (considering each of the layers that forms the semiconductor) at a certain point. If, for example, the semiconductor device is a solar cell, it is distinguished between elemental units for modeling perimetral regions, elemental units for modeling non- illuminated inner regions because of the presence of opaque metallic regions that serves as collectors of the generated current (the so called bus and front grid), or elemental units for modeling illuminated regions. Each elemental unit is made up of circuits so that the calculation of the currents and voltages at different parts of the circuit is allowed, i.e., almost at each semiconductor layer of the physical device.
   In the description of the implementation of this invention, presented later, the elemental units used will be explained with an example.
- *The model comprises at least elemental units modeling the perimetral regions and elemental units modeling inner regions of the semiconductor device.*
   In the most general case, the distinction is made between different kinds of elemental units used in the inner regions of the solar cell, where each elemental unit is related to the surrounding elemental units; and, the elemental units used for the perimetral regions, where the elemental units do not have other adjacent elemental units in the external region.
- *The behavior of each elemental unit describes the transversal structure of the semiconductor device in a point of the main plane associated to said elemental unit, and it is represented by a set of interconnected elemental modules where each one is associated to a physical effect or component of the semiconductor device in the transversal direction, and where each module is composed by at least a simple electronic component.*
   This is the manner used for this method in accordance with the state-of-the-art, and different modules are known depending on the function of each layer of the semiconductor device.
   The modules are interconnected vertically (in the direction perpendicular to the main plane of the device).
   In the present invention, the module used for the tunnel junction model is characterized, as will be shown later.
*The whole behavior of the semiconductor device is simulated following the following steps:*
- *a circuit resulting from connecting the totality of the elemental units is generated.*
   Each one of the modules is interconnected in order to form an elemental unit. In turn, the elemental units are interconnected forming a single circuit representing the whole semiconductor device.
- *a non-linear equation system associated to the circuit, as well as the unknown variables, i.e., the voltages and currents, is obtained.*
   in this step, the equation system which allows the determination of the most relevant variables (the voltages and currents) is defined. This equation system is non-linear one, among other reasons, because of the presence of modules in the elemental units with a non-linear behavior, and also because of the possible dependence of some components on the values of the unknown variables, for example when the value of a resistor depends on the voltage at its terminals.
- *An initial guess to the unknown voltages and currents is made.*
   As in any iterative numerical method, an initial value for the variables is needed, the initial guess, for the unknown variables in order to start the iterative method.
- *The system is solved by means of an iterative procedure up to a stop-conditions is met.*
   For instance, an iterative method based on the Newton-Raphson algorithm which exhibits a reasonable behavior concerning convergence.

Once set the steps of the method, it is characterized by the incorporation of a module which models the tunnel junction by using a combination of a functional element and one or more resistors placed parallel to the main plane of the semiconductor device. The *functional element* allows to fit the behavior of the tunnel junction to the actual behavior observed on this kind of junctions, however, said behavior prevents the convergence of the classical iterative methods. Nevertheless, the combination of resistors used in the module improves the numerical behavior avoiding the divergence of the iterative methods, while it allows the simulation of devices in which the influence of the behavior of the tunnel junction is important.
*This way, the method is characterized in that the elemental units incorporate as a model for the tunnel junction a combination of:*
- *A functional element to that accounts for the relation between the current and the voltage (I-V) described by means of a characteristic curve comprising four consecutive regions:*
   *a) an ohmic region, with positive slope up to a certain peak current value is reached,*
   *b) a negative resistance region, departing from the peak current and dropping with a negative slope to a local minimum or valley current,*
   *c) an excess current region, departing from the value of valley current and showing a positive slope; and,*
   *d) a diode region exhibiting a steeper slope than the excess current region.*
- *one or more resistors spreading along the main plane allowing the current flow between adjacent elemental units.*

In addition to giving rise to a more realistic model, these lateral resistors allow solving of the whole electronic circuit without convergence problems. This model is also more realistic because this (these) resistor(s) spreading along the main plane allow reproducing currents that are generated in the junction flowing to other places through the same layer. Concerning the convergence issue, it is overcome by the use of the combination of the functional element with the resistor(s), said convergence happens at a certain step in the iterative process, when the current which traverses the semiconductor device (for example, a solar cell) is higher than the peak current of the tunnel junction, no abrupt voltage changes are produced. For instance, when using Newton-Raphson algorithms these changes would give way to important differences between the solutions and, therefore, give rise to a method divergence. The transition between iterations is carried out with minor variations of the unknown variable values, thanks to the fact that the current is allowed to flow horizontally, through the said resistors, to regions of the semiconductor device with a lower vertical current flow. The overall experimental result observed is that the divergence of the method is circumvented, allowing to reach a solution for the equations system.

In the detailed explanation of an exemplary embodiment, a convergence example will be shown.

The methods resulting from different combinations of dependent claims 2 to 7, are also considered through reference to this description.

It is also object of this invention the product constituted by a computer program adapted to execute any of the methods described herein.

### DESCRIPTION OF THE DRAWINGS

These and other characteristics and advantages of the present invention will be clearly seen from the detailed description of a preferred embodiment example, which is only given as an illustrative and non limitative example with reference to the enclosed figures.
- Figure 1: In this figure a scheme of a section of a semiconductor device used as an exemplary embodiment is shown. This example is a triple-junction solar cell, in which the three subcells and the two tunnel junctions interconnecting them are detailed therein. The figure has been magnified in the transversal direction (the one in the vertical direction in the drawing) in order to underline each one of their parts.
- Figure 2: Schematic representation of the model used for solving by means of distributed electronic components circuits. The figure shows a collection of elemental units that, once interconnected, produce a circuit with an equivalent behavior.
- Figure 3: In this figure it is shown the I-V curve (current-voltage) obtained experimentally in the tunnel junction with a peak current (Iₚ) of 10 A, in which the four working regions, delimited by the peak current and peak voltage (Iₚ, Vₚ) and the valley current and valley voltage (Iᵥ, Vᵥ) are presented. This curve will be used in the experiments corresponding to figure 8.
- Figure 4: In this figure it is shown the I-V curve of the tunnel junction used in the exemplary embodiment wherein numerical experiments to test the behavior against convergence have been carried out.
- Figure 5: From left to right it is shown the elemental units scheme corresponding to illuminated areas (U.2.1), dark areas (U.2.2), both being inner regions; and perimetral (U.1) of a dual-junction solar cell containing a tunnel junction. The meaning of the included components is:
r_{M} metal lateral resistance (Ω)
r_{FC} front contact layer vertical resistance (Ω)
r_{ETC} top subcell emitter lateral resistance (Ω)
r_{BTC} top subcell base lateral resistance (Ω)
r_{VTC} top subcell vertical resistance (including the vertical resistance of the base and BSF "Back Surface Field" of the top cell) (Ω)
I_{01TC} top cell neutral regions recombination current density (A/cm²) I_{02TC} top cell space charge region recombination current density (A/cm²) rp_{TC} top subcell shunt resistance (Ω)
I_{L} generated photocurrent density (A/cm²)
I_{Tj} tunnel junction current density (A/cm²)
r_{EBC} bottom subcell emitter lateral resistance (Ω)
r_{BBC} bottom subcell base lateral resistance (Ω)
r_{VBC} bottom subcell vertical resistance (including the vertical resistance of the base and BSF "Back Surface Field" of the bottom cell) (Ω)
I_{01BC} bottom cell neutral regions recombination current density (A/cm²) I_{02BC} bottom cell space charge region recombination current density
   (A/cm²)
r_{pBC} bottom cell shunt resistance (Ω)

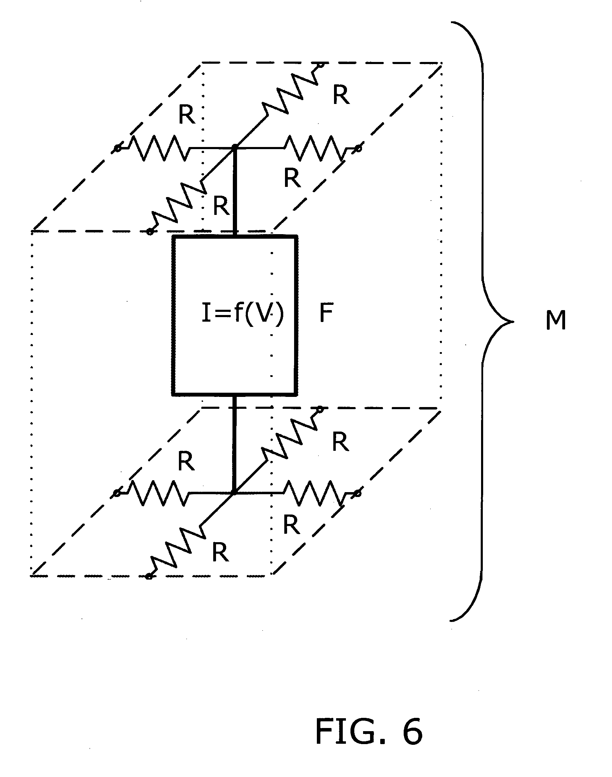

- Figure 6: In this figure it is shown an exemplary embodiment of the module which allows to characterize the tunnel junction by combining a functional element, which reproduces the characteristic I-V curve of the tunnel junction, and several resistors.

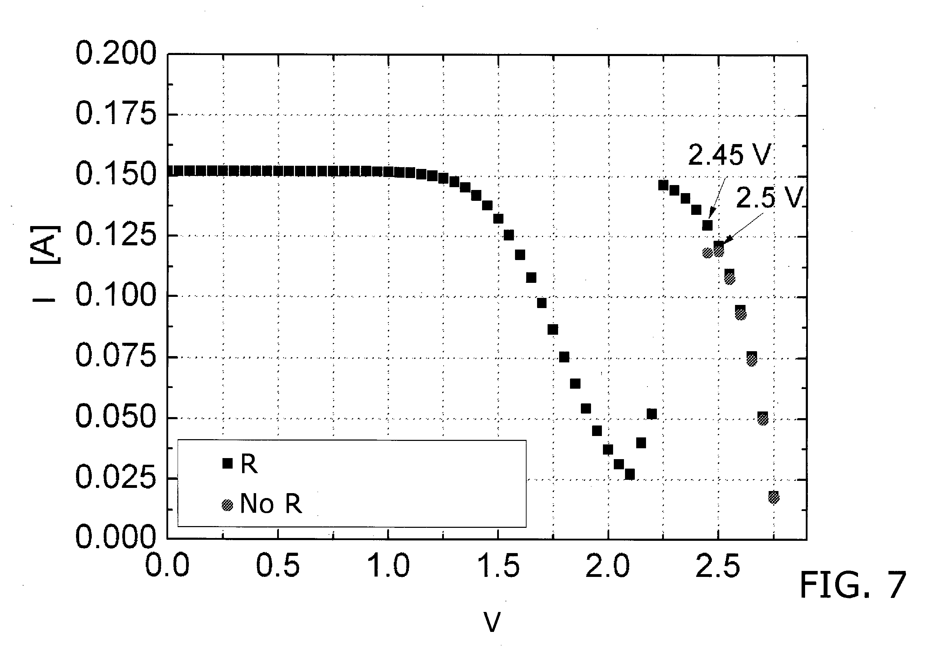

- Figure 7: In this figure, a different behavior concerning the convergence of the solar cell considered in the exemplary embodiment is observed when the model incorporates resistors spreading along the main plane and vice versa.

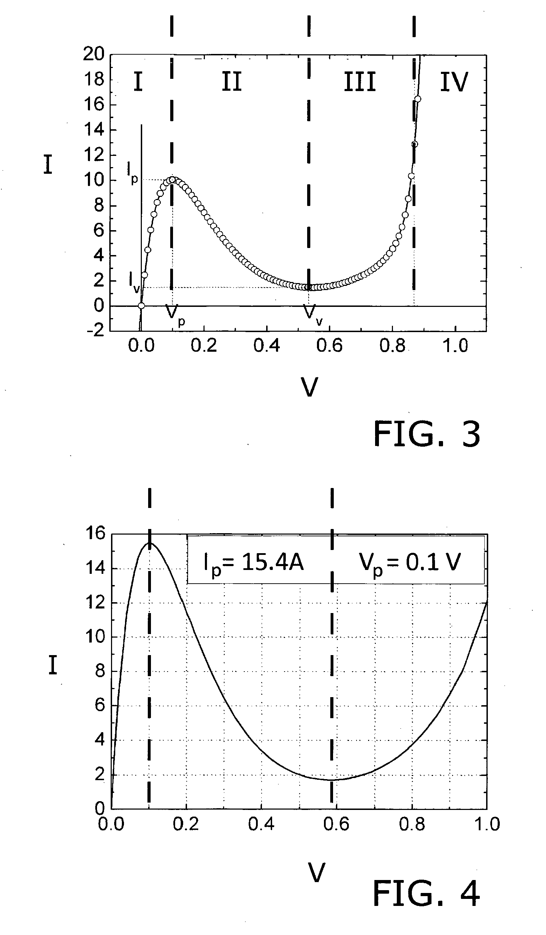

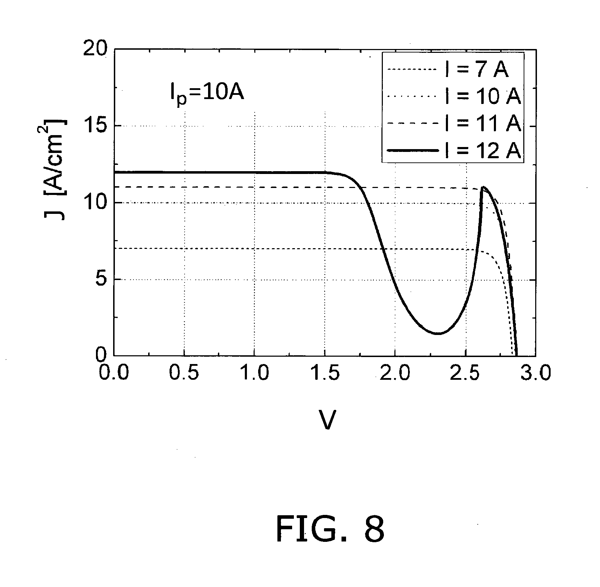

- Figure 8: This figure shows I-V curve examples obtained of the solar cell used in the exemplary embodiment of a dual-junction solar cell including a tunnel junction characterized by a functional element according to the curves shown in figure 3, in order to illustrate the performance of the model object of the present invention given that it permits to reproduce the real behavior, which is not reproducible otherwise.

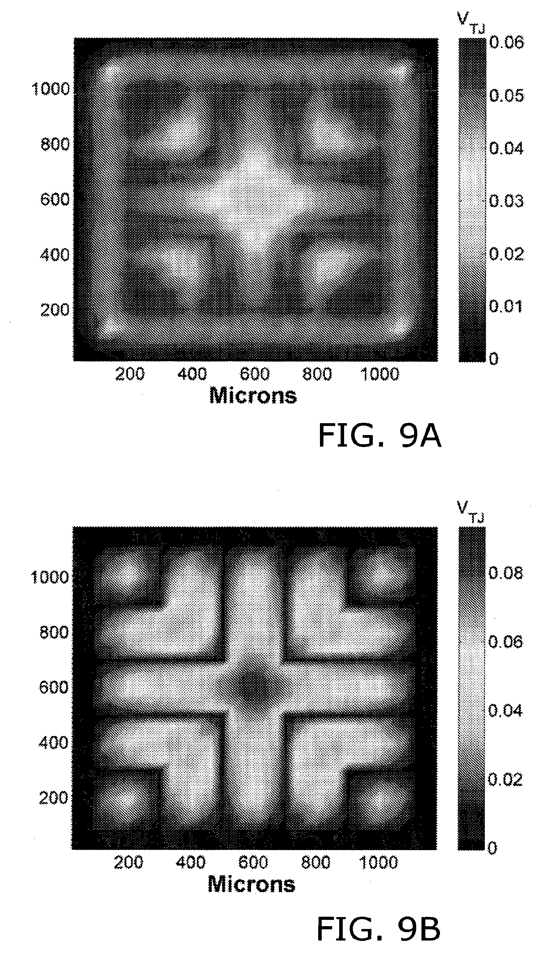

- Figures 9A, 9B, 10A, 10B, 11 y 12: In all these figures are shown false-color plots (in grayscale) of the voltage at the tunnel junction, in simulations of solar cells (with an area of 1 mm²) in which the current of the solar cell is higher than the peak current of the tunnel junction.
Figures 9A, 10A, 11 and 12 correspond to simulations in which the circuit module associated to the tunnel junction incorporates horizontal resistors according to an embodiment of the invention in which the convergence of the method is observed.
Figure 9A shows the results of a simulation in which the voltage at the terminals is of 2.50V.

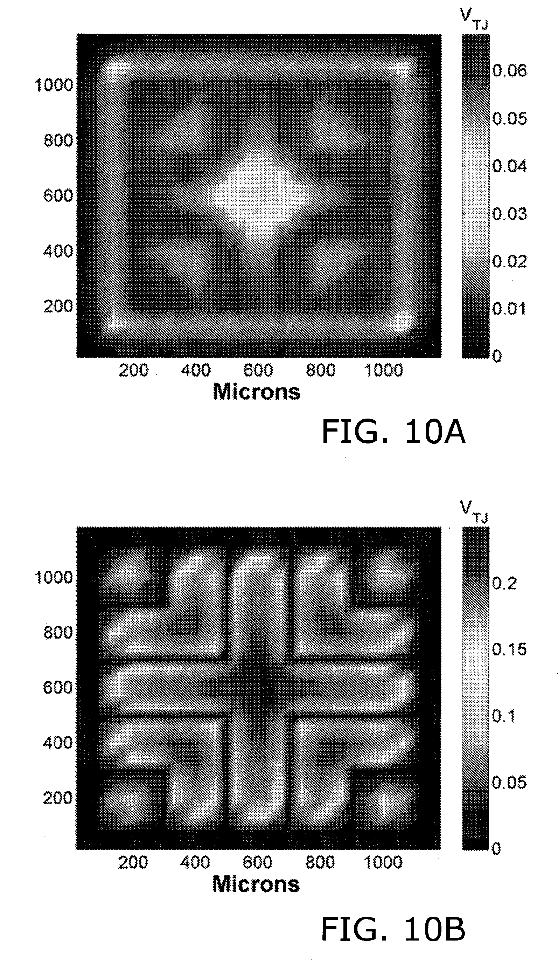

Figure 10A shows the results of a simulation in which the voltage at the terminals is of 2.45V.

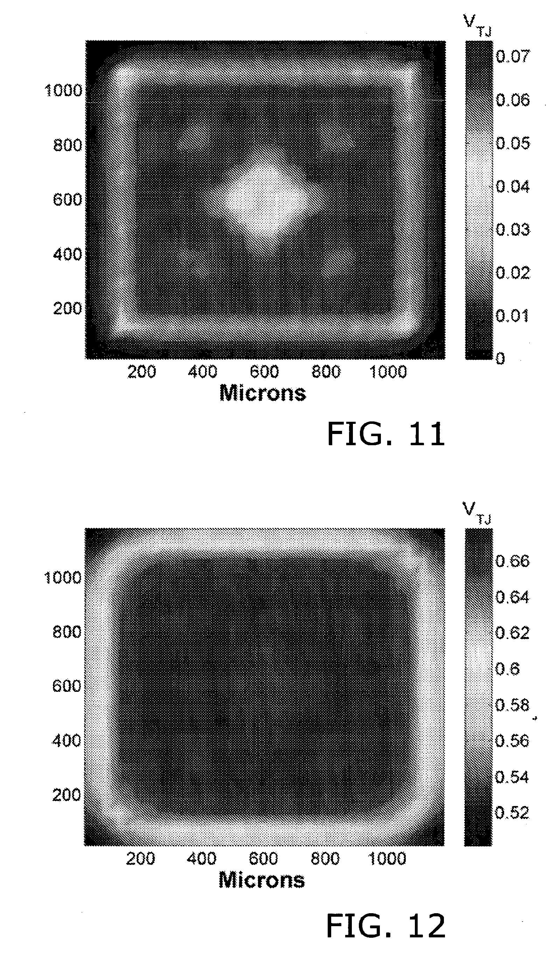

Figure 11 shows the results of a simulation in which the voltage at the terminals is of 2.40V.
Figure 12 shows the results of a simulation in which the voltage at the terminals is of 2.10V.
Figures 9B and 10B correspond to simulations in which the circuit module associated to the tunnel junction does not contain horizontal resistors, showing abrupt voltage changes, which impede the convergence of the iterative calculation method.
Figure 9B shows the results of a simulation in which the voltage at the terminals of the solar cell is of 2.50V.
Figure 10B shows the results of a simulation in which the voltage at the terminals is of 2.45V.
For values of 2.40V and 2.10V there are not plots such as those in figures 9B y 10B due to the non-convergence caused by the lack of horizontal resistances.

### DETAILED DESCRIPTION OF THE INVENTION

The present invention consists in a method implemented in a computer, for the numerical simulation of a semiconductor device comprising one or more tunnel junctions. This semiconductor device is preferably a solar cell, and this is the case in the exemplary embodiment considered in this detailed description of the invention although it can be applied to any other semiconductor device.

According to the present invention, the simulation of a semiconductor device comprising one or more tunnel junctions can be made before the fabrication of the device in order to assure the proper performance prior to its fabrication, or afterwards, aiming to correct possible anomalies found. It is also used with the purpose of fitting and extracting parameters from the experimental curves and also to optimize the device looking for an improved performance under certain real operating conditions.

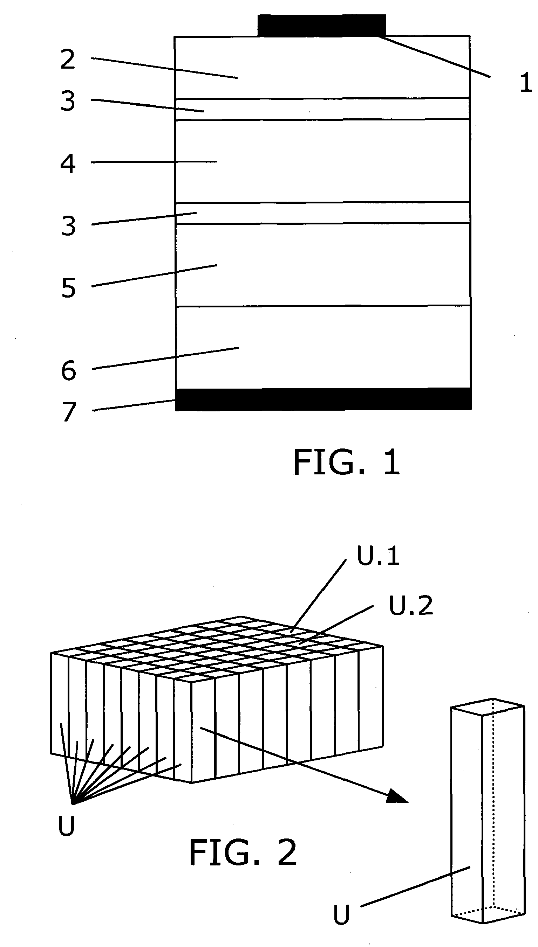

Figure 1 show the structure of a solar cell, the physical device which will be modeled to simulate its behavior. This way, the physical device is replaced by its model in order to calculate the desired variables, such as the voltages and currents.

The layered structure of the solar cell is made up of the following parts, enumerated in an upwards sense according to the arrangement shown in the figure:
- a back contact (7),
- a substrate (6),
- a bottom subcell (5),
- a first tunnel junction (3),
- a middle subcell (4),
- a second tunnel junction (3),
- a top subcell (2),
- A front contact (1).

Additionally, the top subcell (2) can be provided with an anti-reflection coating. The front contact (1) and the back contact (7) allow the extraction of the current generated by the semiconductor device. The solar cell shows a main plane so that each part described is arranged parallel to this main plane. There can be cases in which this plane could adopt a certain degree of curvature or bending; however, it would be still identified a main surface and a transversal direction (perpendicular to this plane) which in every case will be shown as the vertical direction.

Once established the solar cell structure intended to be simulated, the discretization or division into elemental units (U) is carried out. These elemental units have been represented as prisms so that the arrangement of all these prisms covers all all the area of the main plane of the solar cell, as well as its transversal structure. Each elemental unit (U) represents the solar cell structure in accordance with its constituent layers. In figure 2, a distinction has been made for the elemental units (U) located in the periphery of the solar cell (U.1) and the elemental units located inside (U.2).

The simulation process is carried out following these steps:
- The distributed model for the semiconductor device is built, particularly the one of the exemplary embodiment that is a dual-junction solar cell one (or any other semiconductor device) based on a plurality of electronic circuits. The electronic circuits are selected so as to reproduce the electrical behavior of each one of the layers and structures that compose the semiconductor device. Some of these correspond to the tunnel junction. We will call these elemental circuits, elemental modules. Thus, an elemental unit (U) is formed by the combination of all the elemental modules which reproduce the transversal structure of the semiconductor device (in this exemplary embodiment, the solar cell).
- The appropriate data for each electronic component of the electronic circuits are introduced in the model. This fit is anything but an appropriate parameterization that fits each elemental module to the features of the layer that represents and their interactions. The whole equivalent resulting circuit of the solar cell (or any other semiconductor device) is built. Figure 2 shows how in the package of elemental units (U), each elemental unit (U) is in contact with the elemental units (U) that surrounds it. The whole circuit will depend on the connection that results in each elemental circuit connected to the adjacent unit
- The corresponding equation system is built to be solved using a numerical iterative method.

In particular, this last step can be carried out using available software packages such as SPICE, which are suited for the simulation of electronic circuits.

In Figure 3 all the working regions of the tunnel junction are shown: ohmic region (I), negative resistance region (II), excess current region (III) and diode region (IV).

The models used in the state-of-the-art are solely based on a single resistor and they only can model the first region, the ohmic region (I), being further approximated by a straight line.

The model proposed in this invention allows reproducing the fundamental parameters of the tunnel junction as peak current and peak voltage (Iₚ and Vₚ) as well as valley current and valley voltage (Iᵥ and Vᵥ).

As it can be observed; for currents in the solar cell below the peak current of the tunnel junction, both models are valid. However, with the traditional model the effect of the tunnel junction on the characteristic I-V curve is ignored when the current is higher than the peak current of the tunnel junction. This limitation is solved with the model presented in this invention, since a more realistic representation of the characteristic I-V curve is obtained, namely by taking into account the negative resistance region (II), excess current region (III) and the diode region (IV), as corresponds to measurements in real devices.

Figure 4 shows, the real curve used in exemplary embodiment the experiments designed to assess the convergence of the iterative methods used to solve the equation system. These experiments will show the results using the model object of this invention and the result obtained with a less advanced model before this invention.

With the example analyzed, the need to model accurately the tunnel junction is demonstrated, since the configuration of the solar cell I-V curve affects to its maximum power region, which is the working point at which solar cells are generally intended to operate. If the peculiarities of the tunnel junction were not taken into account in the model, the simulations and performance predictions derived from its use would be incorrect and useless.

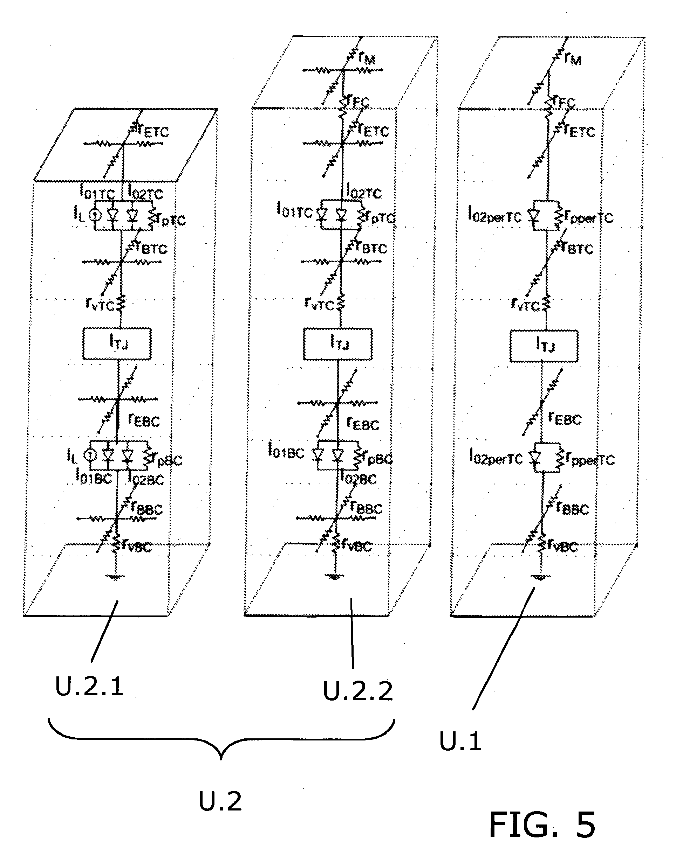

Figure 5 shows three kind of elemental units (U.1, U.2.1, U.2.2) typically used in the distributed circuit method. In this figure, the modeling of these units for a semiconductor device with a single tunnel junction is shown, in order to simplify the scheme. The choice of the electronic components for each of the layers, except for the tunnel junction, is assumed to be comprised in the state-of-the-art of this technique. The used components do not show a characteristic curve with any negative slope at any regions, and hence they do not give way to any convergence problems. It is the tunnel junction what shows this kind of behavior and, therefore, the one causing the convergence problems when a model closer to reality is wanted to be used.

The three kind of elemental units (U) shown from left to right in figure 5 are: an inner region elemental unit (U.2.1) which is illuminated, an inner region elemental unit (U.2.2) which is in the dark; and, an elemental unit (U.1) for the perimetral region. This last elemental unit (U) comprises electronic components which model the behavior of the perimetral region, so that the unit (U) do not have any link towards the right side. It is observed that no component departs from the central axis.

It is object of this invention the incorporation of a module which comprises the components that model the behavior of the tunnel junction (s).

The module (M) is depicted in figure 6, where, in this exemplary embodiment it is observed a middle box that in turn relates modules arranged up and down, the layers of the tunnel junction and a set of resistors (R) spreading along horizontally, i.e., parallel to the main plane.

The middle box incorporates the function that relates the current and voltage, as shown in figures 3 and 4, comprising the 4 working regions of the tunnel junction.

The horizontal resistors (R) allow the current flow along the same layer of the semiconductor.

This combination of a functional element represented by the function according to the I-V curve of the tunnel junction and, the presence of at least one horizontal resistor (R) is the one that allows the appropriate modeling of the tunnel junction and that said modeling yields a system that, when it is solved by means of a numerical method, does not show convergence problems. This is so because, in any step of the iterative process that solves the resulting equation system, at the step when the solar cell current becomes higher than the tunnel junction peak current, no abrupt voltage changes are produced (which could affect the convergence of the Newton-Raphson algorithm used), but this transition is carried out in a smoother way thanks to the lateral current drain towards regions in the device where the current is lower.

It has been carried out experiments that show how the presence of the horizontal resistors (R) enables the convergence of the method. The experiments have been carried out using the I-V curve shown in figure 4, where the peak voltage is 0.1 V and the peak current is 15.4 A. The convergence or divergence of the method is achieved depending on whether there are incorporated resistors (R) inside the module which models the tunnel junction or not.

Figure 7 shows the results of two simulations and figures 9A, 9B, 10A, 10B, 11 y 12 show the behavior of the voltage in the tunnel junction for these simulations. It has been observed in this example that the iterative method does not converge for voltages at the terminals of the cell below 2.45 V, when the lateral resistors (R) are not used. It can be observed how, as the voltage applied to the solar cell is swept from 2.50V to 2.45V, the voltage at the tunnel junction varies smoothly (figures 9A and 10A) when horizontal resistors (R) are used, while without these horizontal resistors (R) the voltage increases abruptly (figures 9B and 10B), so that for the next voltage point of the sweep, the algorithm is not able to find a voltage value in each node of the circuit which is convergent with the previous one. Graph 7 can only be obtained for voltages lower than 2.45 V when the horizontal resistors (R) are used (figures 11 and 12).

Although the combination permits achieve convergence, the use of the I-V curve for the tunnel junction that mimics the real behavior, further allows the simulation of semiconductor devices for conditions that were not possible by now.

In figure 8 it is illustrated the function of the current flow resistors (R) in the tunnel junction interpreted not from a numerical point of view but from physical one. This interpretation is going to be carried out using again a dual-junction solar cell as an example, whose characteristic I-V is shown in Figure 3.

Recently its has been observed experimentally that it is not strictly necessary that the current through the solar cell be lower than the peak current of the tunnel junction, in order to avoid the appearance of the dip in the solar cell I-V curve shown in Figure 8 [A. Braun, B. Hirsch, E. A. Katz, J. M. Gordon, W. Guter and A. W. Bett, "Localized irradiation effects on tunnel diode transitions in multi-junction concentrator solar cells", Solar Energy Material & Solar Cells, 93 (2009) 1692-1695], but the origin of this phenomenon has not been demonstrated conclusively.

Well, then said phenomenon can be explained thanks to the present invention, in the following way. In practice, solar cells comprise areas covered with and without metal areas. The areas covered with metal are supposed as regions where no photogeneration is produced (since they are in the dark), and thus they can be considered as regions where the short circuit current is null. Therefore, said regions can be considered as current sinks which somehow relax the requirement of the peak current of the tunnel junction being equal or higher than whole short circuit current of the solar cell. In the simulation, these current sinks cannot be effective if the lateral current flow is not allowed. This is why this effect cannot be explained with the traditional model for the tunnel junction consisting on a resistor. On the contrary, the present invention contemplates the lateral current flow, so that, though being low the tunnel current that it is able to drain the tunnel junction horizontally to areas in the dark, is enough to allow that the solar cell I-V curve does not exhibit the dip for current values above the tunnel junction peak current, as was observed experimentally. This can be observed also in the simulation result for a solar cell current of 11A higher than the peak current of the tunnel junction (Iₚ=10A).

It is also object of the present invention a module (M) in which the value of the resistors (R) depend on the temperature or on the voltage. In this case, the module (M) allows simulating situations in which inhomogeneities can exist throughout the main plane because of these effects.

## Claims

1. Computer-implemented method for the numerical simulation of a semiconductor device comprising one or more tunnel junctions, preferably a solar cell, wherein:
• the semiconductor device has a main plane and is described by a model featuring electronic components distributed along this said main plane that comprises interconnected elemental units (U),
• the model comprises at least elemental units (U.1) modeling the perimetral regions and elemental units (U.2) modeling the inner regions of the semiconductor device,
• the behavior of each elemental unit (U) describes the transversal structure of the semiconductor device at the point in the main plane associated to that elemental unit and it is represented by a set of interconnected elemental modules where each one is associated to a physical effect or component of the semiconductor device in the transversal direction; and, where each elemental module is composed of at least one simple electronic component;
where the whole behavior of the semiconductor device is simulated following the following steps:
• a circuit resulting from connecting the totality of the elemental units (U) is generated,
• a non-linear equation system associated to the circuit, as well as the unknown variables , i.e., the unknown voltages and the currents, is obtained,
• an initial guess to the unknown voltages and currents is made,
• the system is solved by means of an iterative process up to a stop-condition is met,
where the method is **characterized in that** the elemental units incorporate as the module (M) for the tunnel junction a combination of
• a functional element that accounts for the relation between the current and the voltage I=f(V) described by means of a characteristic curve comprising four consecutive regions:
a) an ohmic region, with positive slope up to a certain peak current value (Iₚ) is reached,
b) a negative resistance region, departing from the peak current (Iₚ) and dropping with a negative slope to a local minimum (Iᵥ) or the valley current,
c) an excess current region, departing from the valley current (Iᵥ) and showing a positive slope; and,
d) a diode region, exhibiting a steeper slope than the excess current region; and,
• one or more resistors (R) spread along the main plane allowing the current flow between adjacent elemental units.

2. A method according to claim 1 wherein the semiconductor device is a solar cell and among the elemental units (U) which model the inner regions of the semiconductor device there are elemental units (U) for region in the dark (U.2.2) and elemental units for illuminated regions (U.2.1).

3. A method according to claim 1 wherein an iterative method is based on the Newton-Raphson algorithm.

4. A method according to claim 1 wherein at least one of the resistors (R) in the tunnel junction model depends on the temperature.

5. A method according to claim 1 wherein at least one of the resistors (R) spreading along the main plane in the tunnel junction model depends on the voltage.

6. A method according to claim 1 wherein the functional element used to account for the relation between the voltage and the current in the tunnel junction, described by means of a characteristic curve comprising four consecutive regions, is represented by means of an analytic expression.

7. A method according to claim 1 wherein the functional element used to account for the relation between the voltage and the current in the tunnel junction, described by means of a characteristic curve comprising four consecutive regions, is represented by means of a look-up table.

8. A product comprising a software program comprising computer instructions to execute any of the methods said in claims 1 to 7.

## Patentansprüche

1. Computerimplementiertes Verfahren für die numerische Simulation einer Halbleitervorrichtung, die einen oder mehrere Tunnelübergänge aufweist, vorzugsweise einer Solarzelle, wobei:
- die Halbleitervorrichtung eine Hauptebene hat und durch ein Modell beschrieben wird, das mit elektronischen Bauteilen ausgestattet ist, die entlang dieser Hauptebene verteilt sind, und das untereinander verbundene elementare Einheiten (U) aufweist,
- das Modell wenigstens elementare Einheiten (U.1), welche die umlaufenden Bereiche modellieren, und elementare Einheiten (U.2), welche die inneren Bereiche der Halbleitervorrichtung modellieren, aufweist,
- das Verhalten jeder elementaren Einheit (U) die transversale Struktur der Halbleitervorrichtung an dem Punkt in der Hauptebene beschreibt, der zu dieser elementaren Einheit gehört, und es durch einen Satz untereinander verbundener elementarer Module dargestellt ist, wobei jedes zu einem physikalischen Effekt oder einem Bauteil der Halbleitervorrichtung in der transversalen Richtung gehört; und wobei jedes elementare Modul aus wenigstens einem einfachen elektronischen Bauteil aufgebaut ist;
wobei das gesamte Verhalten der Halbleitervorrichtung den folgenden Schritten folgend simuliert wird:
- eine Schaltung, die sich aus dem Verbinden der Gesamtheit der elementaren Einheiten (U) ergibt, wird erzeugt,
- ein nicht-lineares Gleichungssystem, das zu der Schaltung gehört, ebenso wie die unbekannten Variablen, d.h. die unbekannten Spannungen und Ströme, werden gewonnen,
- es wird eine Anfangsschätzung für die unbekannten Spannungen und Ströme vorgenommen,
- das System wird mit Hilfe eines iterativen Verfahrens gelöst, bis eine Stoppbedingung erfüllt ist,
wobei das Verfahren **dadurch gekennzeichnet ist, dass** die elementaren Einheiten als das Modul (M) für den Tunnelübergang enthalten: eine Kombination aus:
- einem funktionalen Element, das die Beziehung zwischen dem Strom und der Spannung I=f(V) berücksichtigt, die mit Hilfe einer charakteristischen Kurve beschrieben wird, die vier aufeinanderfolgende Bereiche aufweist:
a) einen ohmschen Bereich mit einer positiven Steigung bis ein gewisser Spitzenstromwert (Ip) erreicht wird,
b) einen Bereich mit negativem Widerstand, der bei dem Spitzenstrom (Ip) beginnt und mit einer negativen Steigung zu einem lokalen Minimum (Iv) oder dem Talstrom abfällt,
c) einen Überstrombereich, der bei dem Talstrom (Iv) beginnt und eine positive Steigung zeigt; und
d) einen Diodenbereich, der eine steilere Steigung als der Überstrombereich zeigt; und
- einen oder mehrere Widerstände (R), die entlang der Hauptebene verteilt sind, was ermöglicht, dass der Strom zwischen benachbarten elementaren Einheiten fließt.

2. Verfahren nach Anspruch 1, wobei die Halbleitervorrichtung eine Solarzelle ist und es unter den elementaren Einheiten (U), welche die inneren Bereiche der Halbleitervorrichtung modellieren, elementare Einheiten (U) für den Bereich in den dunklen (U.2.2) und elementare Einheiten für beleuchtete Bereiche (U.2.1) gibt.

3. Verfahren nach Anspruch 1, wobei ein iteratives Verfahren auf dem Newton-Raphson-Algorithmus basiert.

4. Verfahren nach Anspruch 1, wobei wenigstens einer der Widerstände (R) in dem Tunnelübergangsmodell von der Temperatur abhängt.

5. Verfahren nach Anspruch 1, wobei wenigstens einer der Widerstände (R), die entlang der Hauptebene verteilt sind, in dem Tunnelübergangsmodell von der Spannung abhängt.

6. Verfahren nach Anspruch 1, wobei das funktionale Element, das verwendet wird, um die Beziehung zwischen der Spannung und dem Strom in dem Tunnelübergang zu berücksichtigen, die mit Hilfe einer charakteristischen Kurve, die vier aufeinanderfolgende Bereiche aufweist, beschrieben wird, mit Hilfe eines analytischen Ausdrucks dargestellt wird.

7. Verfahren nach Anspruch 1, wobei das funktionale Element, das verwendet wird, um die Beziehung zwischen der Spannung und dem Strom in dem Tunnelübergang zu berücksichtigen, die mit Hilfe einer charakteristischen Kurve, die vier aufeinanderfolgende Bereiche aufweist, beschrieben wird, mit Hilfe einer Nachschlagtabelle dargestellt wird.

8. Produkt, das ein Softwareprogramm aufweist, das Computeranweisungen aufweist, um jedes der in den Ansprüchen 1 bis 7 genannte Verfahren auszuführen.

## Revendications

1. Procédé mis en oeuvre par un ordinateur pour la simulation numérique d'un dispositif à semi-conducteurs comprenant une ou plusieurs jonctions tunnel, de préférence une cellule solaire, dans lequel :
le dispositif à semi-conducteurs a un plan principal et est décrit par un modèle caractérisant des composants électroniques répartis le long de ce dit plan principal qui comprend des unités élémentaires (U) interconnectées,
le modèle comprend au moins des unités élémentaires (U.1) modélisant les régions périphériques et des unités élémentaires (U.2) modélisant les régions intérieures du dispositif à semi-conducteurs,
le comportement de chaque unité élémentaire (U) décrit la structure transversale du dispositif à semi-conducteurs au niveau du point dans le plan principal associé à cette unité élémentaire et il est représenté par un ensemble de modules élémentaires interconnectés où chacun est associé à un effet ou à un composant physique du dispositif à semi-conducteurs dans la direction transversale ; et, où chaque module élémentaire est composé d'au moins un simple composant électronique ;
où le comportement global du dispositif à semi-conducteurs est simulé selon les étapes suivantes :
un circuit résultant de la connexion de la totalité des unités élémentaires (U) est généré,
un système d'équations non linéaires associé au circuit, ainsi que les variables inconnues, c'est-à-dire, les tensions et les courants inconnus, sont obtenus,
une hypothèse initiale est effectuée pour les tensions et les courants inconnus,
le système est résolu au moyen d'un processus itératif jusqu'à ce qu'une condition d'arrêt soit satisfaite,
où le procédé est **caractérisé en ce que** les unités élémentaires incorporent, en tant que module (M) pour la jonction tunnel, une combinaison
d'un élément fonctionnel qui prend en compte la relation entre le courant et la tension I = f(V) décrite au moyen d'une courbe de caractéristique comprenant quatre régions consécutives :
a) une région ohmique, avec une pente positive jusqu'à ce qu'une certaine valeur de courant crête (Iₚ) soit atteinte,
b) une région de résistance négative, partant du courant crête (Ip) et chutant avec une pente négative jusqu'à un minimum local (Iᵥ) ou au courant de creux,
c) une région de courant excédentaire, partant du courant de creux (Iᵥ) et présentant une pente positive ; et
d) une région de diode, présentant une pente plus raide que celle de la région de courant excédentaire ; et
d'une ou de plusieurs résistances (R) réparties le long du plan principal permettant la circulation de courant entre des unités élémentaires adjacentes.

2. Procédé selon la revendication 1, dans lequel le dispositif à semi-conducteurs est une cellule solaire et, parmi les unités élémentaires (U) qui modélisent les régions intérieures du dispositif à semi-conducteurs, il existe des unités élémentaires (U) pour la région dans l'obscurité (U.2.2) et des unités élémentaires pour les régions éclairées (U.2.1).

3. Procédé selon la revendication 1, dans lequel un procédé itératif est basé sur un algorithme de Newton-Raphson.

4. Procédé selon la revendication 1, dans lequel au moins l'une des résistances (R) dans le modèle de jonction tunnel dépend de la température.

5. Procédé selon la revendication 1, dans lequel au moins l'une des résistances (R) réparties le long du plan principal dans le modèle de jonction tunnel dépend de la tension.

6. Procédé selon la revendication 1, dans lequel l'élément fonctionnel utilisé pour prendre en compte la relation entre la tension et le courant dans la jonction tunnel, décrite au moyen d'une courbe de caractéristique comprenant quatre régions consécutives, est représenté au moyen d'une expression analytique.

7. Procédé selon la revendication 1, dans lequel l'élément fonctionnel utilisé pour prendre en compte la relation entre la tension et le courant dans la jonction tunnel, décrite au moyen d'une courbe de caractéristique comprenant quatre régions consécutives, est représenté au moyen d'une table de correspondance.

8. Produit comprenant un programme logiciel comprenant des instructions d'ordinateur pour exécuter l'un quelconque des procédés présentés dans les revendications 1 à 7.
